**Europäisches Patentamt**

**European Patent Office**

**Office européen des brevets**

(19)

(11) Veröffentlichungsnummer : **0 023 063**
**B1**

(12) **EUROPÄISCHE PATENTSCHRIFT**

(45) Veröffentlichungstag der Patentschrift :
13.10.82

(21) Anmeldenummer : 80200671.8

(22) Anmeldetag : 09.07.80

(51) Int. Cl.³ : **H 01 F 10/28, C 30 B 29/28**

(54) **Einkristall auf der Basis von Seltenerdmetall-Gallium-Granat und magnetische Dünnschichtanordnung mit einem monokristallinen Granat-Substrat.**

(30) Priorität : 12.07.79 DE 2928176
07.03.80 DE 3008706

(43) Veröffentlichungstag der Anmeldung :
28.01.81 (Patentblatt 81/04)

(45) Bekanntmachung des Hinweises auf die Patenterteilung : 13.10.82 Patentblatt 82/41

(84) Benannte Vertragsstaaten :
CH DE FR GB IT LI

(56) Entgegenhaltungen :
DE A 2 434 251
FR A 2 121 045

(73) Patentinhaber : Philips Patentverwaltung GmbH
Steindamm 94
D-2000 Hamburg 1 (DE)
DE
N.V. Philips' Gloeilampenfabrieken
Groenewoudseweg 1
NL-5621 BA Eindhoven (NL)
CH FR GB IT LI

(72) Erfinder : Matelka, Dieter, Dr.
Seerosenstrasse 16
D-2081 Ellerbek (DE)
Erfinder : Laurien, Rolf
Am Wall 53
D-2080 Pinneberg (DE)

(74) Vertreter : Auer, Horst, Dipl.-Ing. et al
Philips Patentverwaltung GmbH Steindamm 94
D-2000 Hamburg 1 (DE)

« Einkristall auf den Basis von Seltenerdmetall-Gallium-Granat und magnetische Dünnschichtanordnung mit einem monokristallinen Granat-Substrat »

Die Erfindung betrifft einen Einkristall auf der Basis von Seltenerdmetall-Gallium Granat sowie eine magentische Dünnschichtanordnung mit einem monokristallinen Seltenerdmetall-Gallium-Granat-Substrat, das eine monokristalline magnetische Schicht aus Granatmaterial trägt.

Seltenerdmetall-Granateinkristalle $A^{3+}_3 B^{3+}_5 O_{12}$ (A = Gd, Sm, Nd ; B ist insbesondere Ga), mit Gitterkonstanten $a_0$ im Bereich von 1,230 nm bis 1,250 nm werden vorzugsweise als Substrate von z.B. 0,8 mm Dicke für magnetische Speichermaterialien in der Magnetblasentechnik (Informationsspeichertechnik unter Verwendungmobiler magnetischer Zylinderdomänen) benutzt (vgl. IEEE Transactions Mag-7 (1971), S. 404).

Auf diesen Substratkristallen läßt man bekanntlich in einem Flüssigphasen- oder Gasphasen-Epitaxieprozeß dünne magnetische Granatschichten (Speichermaterial) von einigen um Dicke, z.B. 5 μm, aufwachsen. Solche Granatschichten können nur dann mit der erforderlichen Störungsfreiheit und Perfektion auf dem vorgegebenen Substrat aufwachsen, wenn Substrat und epitaxiale Schicht nahezu die gleiche kristallographische Gitterkonstante besitzen.

Für die Informationsspeichertechnik nach dem magnetooptischen Speicherverfahren unter Verwendung des magnetooptischen Faraday-Effektes zum Auslesen der Information (vgl. J. Appl. Phys. 40 (1969), S. 1429-1435) kann der Gütefaktor des Speichermaterials, vorzugsweise von Gadolinium-Eisen-Granaten, beträchtlich erhöht werden, wenn eine genügende Menge Wismut in das Speichermaterial eingebaut wird, was eine wesentliche Erhöhung der Faraday-Drehung bewirkt (DE-OS 23 49 348). Da der Einbau von Wismut die Gitterkonstante vergrößert, muß in diesem Fall auch ein Substrat mit entsprechender Gitterkonstante $a_0$, vorzugsweise in der Nähe von 1,249 nm, verwendet werden.

Bisher ist man zu diesem Zweck von Neodym-Gallium-Granat $Nd_3Ga_5O_{12}$ ($a_0$ = 1,250 nm) oder entsprechenden Mischkristallen ausgegangen (DE-OS 24 34 251).

Derartige Einkristalle werden üblicherweise als lange Stäbe aus einer Schmelze gezüchtet, z.B. nach einem in « Solid State Communications » 2 (1964), S. 229-231 beschriebenen Verfahren. Anschließend werden von diesen nichtmagnetischen Granat-Stäben Einkristallscheiben gewünschter Dicke als Keimunterlage für magnetische Granatschichten abgeschnitten. Die Herstellung magnetischer Granatschichten wird z.B. in der Arbeit von W. Tolksdorf in IEEE Trans. mag. MAG-11 (1975) S. 1074 ff beschrieben.

Wie oben dargestellt, ist also sowohl zur Vermeidung von Spannungsrissen in der aufgewachsenen magnetischen Schicht als auch zur Einstellung der magnetischen Eigenschaften eine Anpassung der Gitterkonstanten der Keimunterlage an die der Schicht erforderlich. Durch Auswahl eines geeigneten Seltenerd-Gallium-Granats ($SE_3GA_5O_{12}$ ; SE = Y, Gd, Sm, Nd) wird eine Grobanpassung der Gitterkonstanten erzielt, die sich in der Praxis jedoch als nicht ausreichend erwiesen hat.

Aus der DE-OS 24 34 251 ist ein Substratkristall auf der Basis von Seltenerdmetall-Gallium-Granat mit der allgemeinen Formel

$$A^{3+}_{3-x} B^{2+}_x Ga^{3+}_{5-x} C^{4+}_x O_{12}$$

(A = Gd, Sm oder Nd ; B = Ca, Sr oder Mg ; C = Zr oder Sn ; $0,2 \leq x \leq 0,8$) bekannt, bei welchem eine zusätzliche Feinanpassung der Gitterkonstanten durch einen partiellen Ersatz der Kationen des Granatgitters durch Fremdionen angestrebt wird. Es werden hier für Seltenerdmetallionen auf dem Dodekaederplatz $CA^{2+}$- oder $Sr^{2+}$- oder $Mg^{2+}$-Ionen eingebaut, und für Galliumionen auf dem Oktaederplatz des Granatgitters $Zr^{4+}$- oder $Sn^{4+}$-Ionen, wodurch die Gitterkonstante zwischen 1,236 nm und 1,257 nm variiert werden kann.

Ein Nachteil dieser bekannten Zusammensetzungen ist, daß es schwierig ist, Kristalle bis zu einem Durchmesser von maximal 22 mm bei einer genügenden Wachstungsgeschwindigkeit von etwa 2 mm h$^{-1}$ herzustellen.

Wird aus einer Schmelze obigen Zusammensetzungstyps ein Kristall mit zu hoher Ziehgeschwindigkeit gezogen, können sich vor der Wachstumsfront Verunreinigungen anreichern, die zu einer Herabsetzung des Schmelzpunktes und damit zu einer erhöhten lokalen Wachstumsgeschwindigkeit des Kristalls führen. Der Kristall wächst dann nicht in Gleichgewichtszusammensetzung an und neigt zu Spannungen und Versetzungsbildung.

Hierzu ist folgendes auszuführen :

Für die technische Verwendung der genannten Mischeinkristalle als Substrat ist es wichtig, daß bei der Züchtung die Zusammensetzung und damit die Gitterkonstante $a_0$ des Kristalls zwischen Wachstumsbeginn und Wachstumsende nahezu gleich ist. Dies ist nur dann zu erreichen, wenn der Verteilungskoeffizient $K_{eff}$ zwischen Kristall und Schmelze eins oder nahezu eins ist, wobei die Abweichung $\Delta a_0$ nicht größer als $2 . 10^{-4}$ nm sein sollte. Die Bestimmung der Verteilungskoeffizienten erfolgt durch Bestimmung der Kristallzusammensetzung mittels Röntgenfluoreszenzanalyse. Der Wert für $K_{eff}$ ergibt sich aus dem Verhältnis der Konzentrationen der einzelnen Komponenten im Kristall zu den Konzentrationen der einzelnen Komponenten in der Schmelze.

Der Erfindung liegt die Erkenntnis zugrunde, daß man bei Seltenerdmetall-Gallium-Granaten durch gekoppelte Substitution einmal eines Teiles der Seltenerdmetallionen durch geeignete Erdalkalimetallionen wie $Ca^{2+}$ oder $Sr^{2+}$, und zum anderen eines Teiles der Galliumionen durch geeignete Ionen zweiwertiger Elemente wie $Mg^{2+}$

gemeinsam mit geeigneten Ionen vierwertiger Elemente wie $Zr^{4+}$ oder $Sn^{4+}$ zu den gewünschten Kristalleigenschaften gelangen kann, und die anfangs erwähnte magnetische Dünnschichtanordnung ist nach der Erfindung dadurch gekennzeichnet, daß das Substrat die Zusammensetzung

$$A^{3+}_{3-x}B^{2+}_x Ga^{3+}_{5-x-2y}C^{2+}_y D^{4+}_{x+y}O_{12}$$

aufweist, wobei

A = Gadolinium und/oder Samarium und/oder Neodym und/oder Yttrium

B = Calcium und/oder Strontium

C = Magnesium

D = Zirkonium und/oder Zinn

$O < x \leqq 0,7$ ; $O < y \leqq 0,7$ und $x + y \leqq 0,8$.

Der Erfindung liegt außerdem die Erkenntnis zugrunde, daß durch einen Einbau von $Ca^{2+}$-Ionen und/oder $Sr^{2+}$-Ionen neben $Mg^{2+}$- und $Zr^{2+}$- und/oder $Sn^{2+}$-Ionen in einen Gadolinium-Gallium-Granat eine Möglichkeit der Variation der Gitterkonstanten bei einem gleichbleibenden Verteilungskoeffizienten von nahezu 1 möglich ist.

Die mit der Erfindung erzielten Vorteile werden insbesondere bei einer großtechnischen Serienfertigung wirksam. Es ist erwünscht, z.B. Displays möglichst großen Flächeninhalts herstellen zu können, was nur erreicht werden kann, wenn die Substratkristalle einen möglichst großen Durchmesser haben und dabei weitgehend spannungsfrei sind. Außerdem ist es wichtig, daß die Wachstumsgeschwindigkeit dieser Kristalle erhöht wird, um wirtschaftlich arbeiten zu können, während ein bedeutender Vorteil ist, daß bei Verteilungskoeffizienten $K_{eff}$ von nahezu 1 eine gewünschte Gitterkonstante $a_0$ von 1,249 7 nm erreichbar ist, was die Anpassung des Substrats an eine aufzuwachsende Wismut enthaltende Seltenerdmetall-Eisen-Granatschicht garantiert.

Die Erfindung wird nunmehr anhand von Ausführungsbeispielen näher erläutert.

Die Zeichnung zeigt in

Figur 1 eine graphisphe Darstellung der Gitterkonstanten einer Reihe von Mischkristallen mit konstantem Zr-Gehalt in der Schmelze von 0,5 Formeleinheiten gemäß der Erfindung in Abhängigkeit vom Ca- bzw. Mg-Gehalt in der Schmelze.

Figur 2 eine graphische Darstellung der Gitterkonstanten einer Reihe von Mischkristallen mit konstantem Zr-Gehalt in der Schmelze von 0,65 Formeleinheiten gemäß der Erfindung in Abhängigkeit vom Ca- bzw. Mg-Gehalt in der Schmelze.

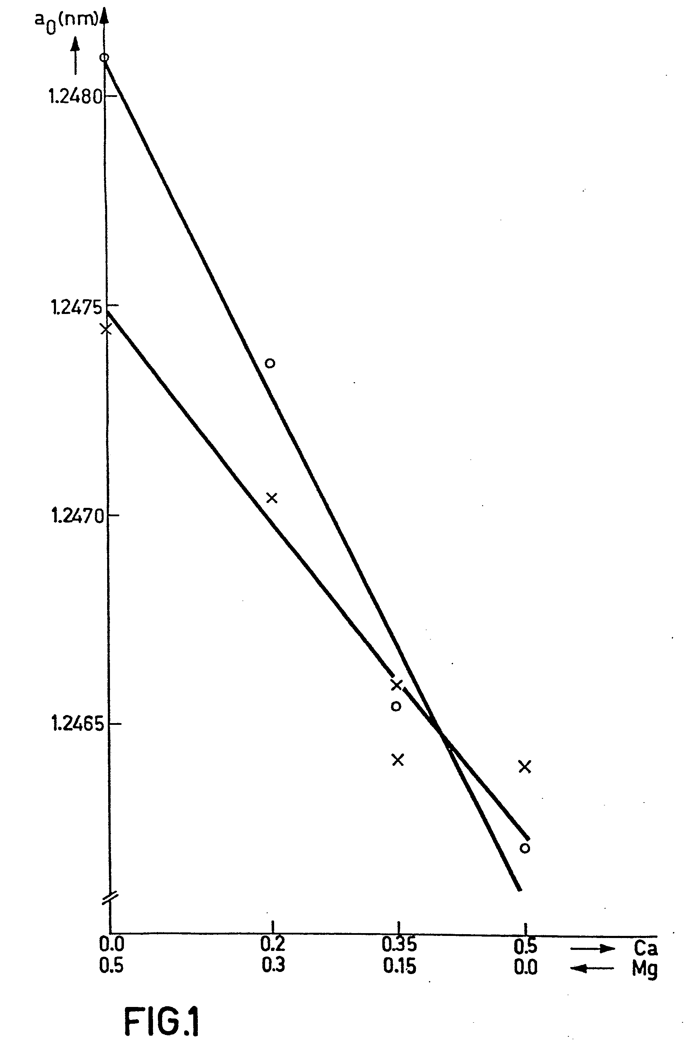

In Fig. 1 sind mit Kreuzen angegeben die Gitterkonstanten des Anfanges (150 g Kristallgewicht) und mit offenen Kreisen die Gitterkonstanten des Endes (450 g Kristallgewicht) des zylindrischen Teiles von Einkristallen gemäß der Erfindung mit konstantem Zr-Gehalt in der Schmelze von 0,5 Formeleinheiten und unterschiedlichen Gehalten an Mg bzw. Ca in der Schmelze (Gesamteinwaage der Ausgangssubstanzen 800 g) dargestellt. Für eine Schmelzzusammensetzung mit einem Ca-Gehalt von ~ 0,4 Formeleinheiten und einem Mg-Gehalt von ~ 0,1 Formeleinheiten wird innerhalb der Meßgenauigkeit keine Änderung der Gitterkonstanten beobachtet. Bei dieser Schmelzzusammensetzung kompensiert sich der Einfluß der Verteilungskoeffizienten auf die Gitterkonstante.

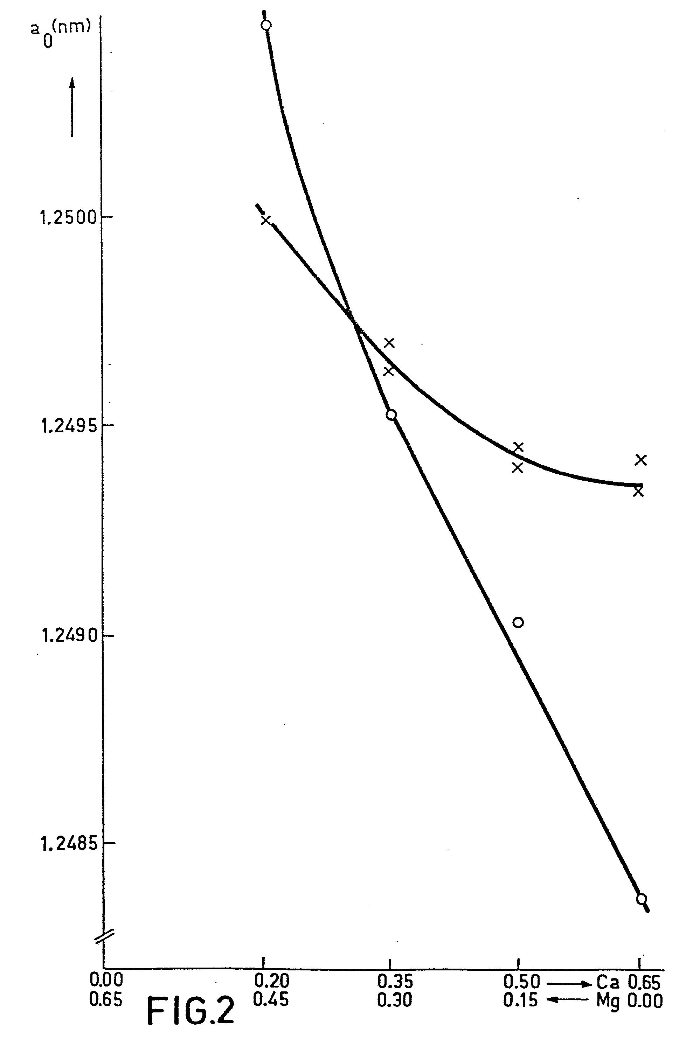

In Fig. 2 sind mit Kreuzen angegeben die Gitterkonstanten des Anfanges (150 g Kristallgewicht) und mit offenen Kreisen die Gitterkonstanten des Endes (450 g Kristallgewicht) des zylindrischen Teiles von Einkristallen gemäß der Erfindung mit konstantem Zr-Gehalt in der Schmelze von 0,65 Formeleinheiten und unterschiedlichen Gehalten an Mg bzw. Ca in der Schmelze (Gesamtgewicht der Ausgangssubstanzen 800 g) dargestellt.

Die optimale Schmelzzusammensetzung scheint für diese Mischkristallreihe bei einem Wert für x von ~ 0,35 und für y von ~ 0,30 Formeleinheiten zu liegen.

Die Züchtung dieser Substratkristalle wird nachstehend beschrieben.

Es wird die Züchtung eines $Gd_{2,6}Ca_{0,4}Ga_{4,1}Mg_{0,25}Zr_{0,65}O_{12}$-Mischkristalls beschrieben :

Die Ausgangssubstanzen (1 947,11 g $Gd_2O_3$, 1 587,65 g $Ga_2O_3$, 92,68 g CaO, 41,63 g MgO und 330,93 g $ZrO_2$ ; Gesamteinwaage 4 000 g) werden gemischt, in Zylinderform gepreßt und bei 1 500 °C in Sauerstoffatmosphäre gesintert.

Anschließend wird der Sinterkörper in einem induktiv beheizten Iridiumtiegel bei ca. 1 800 °C in einer abgeschlossenen Kristallziehapparatur aufgeschmolzen. Durch die Apparatur wird ein Gasgemisch bestehend aus 50 % $N_2$ + 50 % $CO_2$ geleitet. Als Impfkristall dient ein zylinderförmiger Einkristallstab aus Gadolinium-Gallium-Granat. Der Ziehprozeß wird in bekannter Weise nach dem Czochralski-Verfahren durchgeführt. Die Wachstumsgeschwindigkeit beträgt 5,0 mm $h^{-1}$, die Rotationsgeschwindigkeit ~ 40 U $min^{-1}$. Die gezüchteten Kristalle haben eine maximale Länge von 130 mm und einen maximalen Durchmesser von 77 mm. Ihre Gitterkonstante $a_0$ beträgt 1,249 nm, wobei die Abweichung $\Delta a_0$ des Wertes für die Gitterkonstante zwischen Wachstumsbeginn und Wachstumsende nicht mehr als $1 \cdot 10^{-4}$ nm betrug.

Auf die gleiche Weise wie oben beschrieben wurden $Gd_{2,65}Ca_{0,35}Ga_{4,35}Mg_{0,15}Zr_{0,5}O_{12}$-Mischkristalle und $Gd_{2,65}Ca_{0,35}Ga_{4,05}Mg_{0,3}Zr_{0,65}O_{12}$-Mischkristalle gezüchtet. Ihre Gitterkonstanten $a_0$ betrugen 1,247 nm bzw. 1,250 nm, wobei die Abweichung $\Delta a_0$ des Wertes für die Gitterkonstante zwischen Wachstumsbeginn und Wachstumsende auch in diesen Fällen nicht mehr als $1 \cdot 10^{-4}$ nm betrug.

Es ist oben angedeutet, wie ein Teil der Seltenerdmetallionen durch Calciumionen und ein Teil der Galliumionen durch Magnesium und Zirkoniumionen ersetzt wurde. Aufgrund sehr ähnlicher Ionenradien können jedoch statt Calciumionen andere Erdalkalimetallionen, wie z.B. Strontium-$^{2+}$ und statt Zirkoniumionen kann Zinn$^{4+}$ eingebaut werden. Nachfolgend sind die Ionenradien der an den vorliegenden Mischkristallen beteiligten Elemente aufgeführt. Die Seltenerdmetallionen (Ionenradien jeweils in () angegeben) $Gd^{3+}$ (0,106 nm), $Sm^{3+}$ (0,109 nm), $Nd^{3+}$ (0,112 nm) und $Y^{3+}$ (0,102 nm) werden zum Teil substituiert durch $Ca^{2+}$ (0,112 nm) oder $Sr^{2+}$ (0,125 nm). Die Galliumionen $Ga^{3+}$ (0,062 nm) werden auf ihren Oktaederplätzen zum Teil substituiert durch $Mg^{2+}$ (0,072 nm) und durch $Zr^{4+}$ (0,075 nm) oder $Sn^{4+}$ (0,069 nm).

Alle gezüchteten Kristalle waren optisch transparent. Die Kristallperfektion wurde mit einem Polarisationsmikroskop und nach der Schlierenmethode untersucht. Versetzungen und Einschlüsse wurden ermittelt zu $< 5 \cdot 10^{-2}/cm^2$.

Diese Einkristalle eignen sich insbesondere als Substrat für epitaxiale magnetische Granatschichten für magneto-optische Informationsspeicher oder Displays.

Zur Herstellung magnetischer Dünnschichtanordnungen werden nach bekannter Technik (vgl. Appl. Phys. Lett. *19* (1971), S. 486-488, und Journal of Cryst. Growth *17* (1972), S. 322-328) unmagnetische Substrateinkristallscheiben der obigen Zusammensetzungen in eine schmelzflüssige Lösung getaucht, wobei durch einen Flüssigphasen-Epitaxieprozeß Granatschichten z.B. der Zusammensetzung $(Gd, Bi)_3 (Fe, Al, Ga)_5O_{12}$ von etwa 5 μm Dicke aufwachsen.

Zum Einschreiben von Informationen werden diese Dünnschichtanordnungen mit einem Laserstrahl angesteuert ; infolge der damit verbundenen Erwärmung der Granatschicht wird unter gleichzeitiger Einwirkung eines äußeren magnetischen Schaltfeldes die Richtung der Magnetisierung lokal gepolt. Die beim Auslesen des Informationszustandes angewandte Technik (= Nutzbarmachung des magneto-optischen Farraday-Effektes) kann auch für optische Displaysysteme nutzbar gemacht werden. So ist ein Zylinderdomänendisplay vom Projektionstyp bekannt (vgl. IEEE Transactions MAG-7 (1971), S. 370-373), bei dem ebenfalls zur Erhöhung des Bildkontrastes eine beträchtliche Substitution von z.B. eines Seltenerdmetallions pro Formeleinheit durch Wismut erforderlich ist, was die bereits beschriebenen Probleme mit sich bringt und die Notwendigkeit eines Substrates mit erhöhter Gitterkonstante bedingt.

Ein Vorteil großer Substratscheiben ist, daß die Anzahl von Speicherplätzen pro Scheibe erhöht wird. Für bestimmte Anwendungszwecke, z.B. für Reprographiegeräte, ist für eine Speichermatrize eine Speicherplatzkapazität von $256 \times 128$ bit erforderlich. Dies ist nur realisierbar, wenn die Substratscheiben einen Durchmesser von nicht kleiner als 48 mm haben.

## Ansprüche

1. Magnetische Dünnschichtanordnung mit einem monokristallinen Seltenerdmetall-Gallium-Granat-Substrat, das eine monokristalline magnetische Schicht aus Granatmaterial trägt, dadurch gekennzeichnet, daß das Substrat die Zusammensetzung

$$A^{3+}_{3-x}B^{2+}_xGa^{3+}_{5-x-2y}C^{2+}_yD^{4+}_{x+y}O_{12}$$

aufweist, wobei

A = Gadolinium und/oder Samarium und/oder Neodym und/oder Yttrium
B = Calcium und/oder Strontium
C = Magnesium
D = Zirkonium und/oder Zinn
$0 < x \leqq 0,7$ ; $0 < y \leqq 0,7$ und $x + y \leqq 0,8$.

2. Magnetische Dünnschichtanordnung nach Anspruch 1, dadurch gekennzeichnet, daß

$$0,1 \leqq x, y \leqq 0,4 \text{ und } 0,5 \leqq x + y \leqq 0,7.$$

3. Magnetische Dünnschichtanordnung nach den Ansprüchen 1 und 2, dadurch gekennzeichnet, daß das Substrat die Zusammensetzung

$$Gd_{2,65}Ca_{0,35}Ga_{4,05}Mg_{0,3}Zr_{0,65}O_{12}$$

hat.

4. Magnetische Dünnschichtanordnung nach den Ansprüchen 1 und 2, dadurch gekennzeichnet, daß das Substrat die Zusammensetzung

$$Gd_{2,6}Ca_{0,4}Ga_{4,1}Mg_{0,25}Zr_{0,65}O_{12}$$

hat.

5. Einkristall auf der Basis von Seltenerdmetall-Gallium-Granat, gekennzeichnet durch die Zusammensetzung

$$A^{3+}_{3-x}B^{2+}_xGa^{3+}_{5-x-2y}C^{2+}_yD^{4+}_{x+y}O_{12}$$

wobei

A = Gadolinium und/oder Samarium und/oder Neodym und/oder Yttrium
B = Calcium und/oder Strontium
C = Magnesium
D = Zirkonium und/oder Zinn und
$0 < x \leqq 0,7$ ; $0 < y \leqq 0,7$ und $x + y \leqq 0,8$ ist.

## Claims

1. A magnetic thin-layer arrangement having a monocrystalline rare earth-gallium garnet substrate which supports a monocrystalline magnetic layer of garnet material, characterized in that the substrate has the composition

$$A^{3+}_{3-x}B^{2+}_xGa^{3+}_{5-x-2y}C^{2+}_yD^{4+}_{x+y}O_{12}$$

wherein

A = gadolinium and/or samarium and/or neodymium and/or yttrium
B = calcium and/or strontium
C = magnesium
D = zirconium and/or tin

$O < x \leqq 0.7$ ; $O < y \leqq 0.7$ and $x + y \leqq 0.8$.

2. A magnetic thin-layer arrangement as claimed in Claim 1, characterized in that

$$0.1 \leqq x, y \leqq 0.4 \text{ and } 0.5 \leqq x + y \leqq 0.7.$$

3. A magnetic thin-layer arrangement as claimed in Claim 1 and 2, characterized in that the substrate has the composition

$$Gd_{2.65}Ca_{0.35}Ga_{4.05}Mg_{0.3}Zr_{0.65}O_{12}.$$

4. A magnetic thin-layer arrangement as claimed in Claims 1 and 2, characterized in that the substrate has the composition

$$Gd_{2.6}Ca_{0.4}Ga_{4.1}Mg_{0.25}Zr_{0.65}O_{12}.$$

5. A single crystal on the basis of rare earth-gallium garnet, characterized by the composition

$$A^{3+}_{3-x}B^{2+}_{x}Ga^{3+}_{5-x-2y}C^{2+}_{y}D^{4+}_{x+y}O_{12}$$

wherein
A = gadolinium and/or samarium and/or neodymium and/or yttrium
B = calcium and/or strontium
C = magnesium
D = zirconium and/or tin and
$O < x \leqq 0.7$ ; $O < y \leqq 0.7$ and $x + y \leqq 0.8$.

**Revendications**

1. Agencement en couche mince magnétique comportant un substrat monocristallin en grenat de terres rares-gallium, supportant une couche magnétique monocristalline en grenat, caractérisé en ce que le substrat répond à la composition

$$A^{3+}_{3-x}B^{2+}_{x}Ga^{3+}_{5-x-2y}C^{2+}_{y}D^{4+}_{x+y}O_{12}$$

dans laquelle
A = gadolinium et/ou samarium et/ou néodyme et/ou yttrium
B = calcium et/ou strontium
C = magnésium
D = zirconium et/ou étain
$O < x \leqq 0.7$ ; $O < y \leqq 0.7$ et $x + y \leqq 0.8$.

2. Agencement en couche mince magnétique selon la revendication 1, caractérisé en ce que

$$0.1 \leqq x, y \leqq 0.4 \text{ et } 0.5 \leqq x + y \leqq 0.7.$$

3. Agencement en couche mince magnétique selon l'une des revendications 1 ou 2, caractérisé en ce que le substrat répond à la composition

$$Gd_{2.65}Ca_{0.35}Ga_{4.05}Mg_{0.3}Zr_{0.65}O_{12}.$$

4. Agencement en couche mince magnétique selon l'une des revendications 1 ou 2, caractérisé en ce que le substrat répond à la composition

$$Gd_{2.6}Ca_{0.4}Ga_{4.1}Mg_{0.25}Zr_{0.65}O_{12}.$$

5. Monocristal à base de grenat de terres rares-gallium, caractérisé par la composition

$$A^{3+}_{3-x}B^{2+}_{x}Ga^{3+}_{5-x-2y}C^{2+}_{y}D^{4+}_{x+y}O_{12}$$

dans laquelle
A = gadolinium et/ou samarium et/ou néodyme et/ou yttrium
B = calcium et/ou strontium
C = magnésium
D = zirconium et/ou étain
$O < x \leqq 0.7$ ; $O < y \leqq 0.7$ et $x + y \leqq 0.8$.

FIG.1

**0 023 063**

FIG.2